# EUROPÄISCHE PATENTSCHRIFT

(11) **EP 1 440 611 B1**
(45) Veröffentlichungstag und Bekanntmachung des Hinweises auf die Patenterteilung: **13.12.2006**
(21) Anmeldenummer: 02776837.3
(22) Anmeldetag: 17.10.2002
(51) Int. Cl.: H05K 7/14, H02M 7/00

(54) **STROMRICHTEREINHEIT IN MODULBAUWEISE**
MODULAR CONVERTER UNIT
UNITE REDRESSEUR MODULAIRE

(30) Priorität: 31.10.2001 DE 10153748
(43) Veröffentlichungstag der Anmeldung: 28.07.2004
(73) Patentinhaber: SIEMENS AKTIENGESELLSCHAFT, 80333 München (DE)
(72) Erfinder: MÜLLER, Hans-Jürgen, 91074 Herzogenaurach (DE); HOFFMANN, Ingolf, 91074 Herzogenaurach (DE); WEICHSELBAUM, Thomas, 90471 Nürnberg (DE); SCHINN, Volker, 91056 Erlangen (DE); DENGLER, Georg, 96114 Hirschaid (DE)
(86) Internationale Anmeldenummer: PCT/DE2002/003933
(87) Internationale Veröffentlichungsnummer: WO 2003/041471

(56) Entgegenhaltungen:
- EP-A- 0 655 881
- DE-A- 19 845 821
- GB-A- 2 178 243

## Beschreibung

Die Erfindung bezieht sich auf eine Stromrichtereinheit in Modulbauweise und ein Stromrichtergerät, das wenigstens eine Stromrichtereinheit in Modulbauweise aufweist.

Aus der GB 2 178 243 A ist eine kompakte Leistungsanordnung, bestehend aus zwei Leistungseinheiten, bekannt. Jede Leistungseinheit weist mehrere Zweigpaarmodule auf, die auf einer Montageplatte eines Kühlkörpers montiert sind. Diese beiden Leistungseinheiten sind mit ihren Kühlkörpern derart zusammengefügt, dass zwischen diesen kein Spalt mehr auftritt und die bestückten Montageplatten auf gegenüberliegenden Seiten der kompakten Leistungsanordnung angeordnet sind. Mittels zweier Platten wird diese zusammengesetzte Einheit zusammengehalten. Außerdem weist diese kompakte Leistungsanordnung eine Lüftereinheit auf, die mittels eines Kühlluftkanals mit der Einströmseite der beiden Kühlkörper der kompakten Leistungsanordnung verbunden ist. Die Zweigmodule einer jeden Leistungseinheit sind jeweils mittels einer Leiterplatte, die Steuerungs- und/oder Schutzeinrichtungen aufweist, miteinander elektrisch leitend verbunden. Die Anschlüsse der Zweigmodule einer jeden Leistungseinheit sind derartig auf der zugehörigen Leiterplatte verteilt, dass an einer Seite sich die wechselspannungsseitigen und an der anderen Seite die gleichspannungsseitigen Anschlüsse liegen. Dadurch können die gleichspannungsseitigen Anschlüsse der beiden Leistungseinheiten mittels einer Zwischenkreisdrossel miteinander elektrisch leitend verbunden werden. Wechselspannungsseitig ist eine Leistungseinheit mit einem speisenden Netz und die andere Leistungseinheit mit einem Motor verbunden. Anstelle eines Gleichstromzwischenkreis-Umrichters können die Leistungseinheiten eines Gleichspannungszwischenkreis-Umrichters auch als kompakte Leistungsanordnung aufgebaut werden.

Aus der DE 198 45 821 A1 ist eine Stromrichtereinheit in Modulbauweise, insbesondere für Schienenfahrzeuge, bekannt. Diese Stromrichtereinheit besteht aus einem rahmen- oder haubenförmigen Metallgehäuse, in der Art eines Gehäuserahmens, der zur Aufnahme der zu verwendeten Bauteile dient. An dem Gehäuserahmen ist beidseitig je ein Kühlkörper und zentral in dem Gehäuserahmen ein Zwischenkreiskondensator vorgesehen. Beidseitig des Gehäuserahmens sind IGBT-Module montiert. Oberhalb des Gehäuserahmens ist eine Verschienung über Anschlusselemente angeordnet, die Anschlusspunkte des Zwischenkreiskondensators mit DC-Anschlüssen der IGBT-Module elektrisch verbindet. Zwischen Verschienung und Zwischenkreiskondensator sind im Bereich von Kontaktstellen Isolierungen vorgesehen. Der Zwischenkreiskondensator ist auf der Bodenfläche des Gehäuserahmens in bekannter Weise montiert. AC-Anschlüsse der Stromrichtereinheit sind an eine Anschlussleiste geführt, die über Isolatoren mit den Kühlkörpern und dem Gehäuserahmen verbunden sind. Die Stromschienen, die vorzugsweise aus breiten isolierten Kupferbänden besteht, sind an den IGBT-Ausgängen, den AC-Anschlüssen und den Isolatoren befestigt und für eine einseitige Zugänglichkeit, vorzugsweise unterhalb des Gehäuserahmens, auf eine Seite geführt. Die einseitige Anordnung der Anschlüsse gewährleistet eine einfache und schnelle Montage und-Demontage der Stromrichtereinheit. Seitlich und nach oben hin gebildete Öffnungen des Gehäuserahmens werden durch eine Abdeckplatte des Zwischenkreiskondensators und durch die Kühlkörper mit umlaufenden Abdichtungen flächenmäßig abgedeckt. Die anderen beiden sich gegenüberliegenden Seiten des Gehäuserahmens sind jeweils mit zwei Öffnungen versehen und korrespondieren mit den im Gehäuserahmen befestigten Kühlkörpern, die ebenfalls mit umlaufenden Abdichtungen versehen sind. Die Verschienung, die aus elektrisch isolierten deckungsgleich übereinander angeordneten Leitern in der Art von Folien, besteht, wird über die Kontaktstellen auf der Oberseite der Verschienung mit den Anschlusspunkten des Zwischenkreiskondensators und über abgewinkelte seitliche Laschen mit den DC-Anschlüssen der IGBT-Module verschraubt. An dem Gehäuserahmen sind Befestigungsschienen angeordnet, die eine Montage der Einheit in unterschiedlicher Einbaulage zulassen. Die Stromrichtereinheit kann mit diesen Befestigungsschienen in einen Container montiert werden. Die Stromrichtereinheit ist für Wasser- und Luftkühlung auslegbar. Bei Luftkühlung, wird die Kühlfläche durch Kühlrippen in bekannter Form ausgebildet. Bei Wasserkühlung werden entsprechende Wasseranschlüsse für Zu- und Ablauf in bekannter Weise vorgesehen, wobei diese Anschlüsse auf der Seite der Anschlussleiste geführt sind. Durch die Ausgestaltung dieser Stromrichtereinheit wird eine kompakte Baueinheit geschaffen, die z.B. als Phasenbaustein für Wechselrichter, für Vierquadrantsteller bzw. für Bremssteller auch in unterschiedlichen Kombinationen verwendet werden können. Mit einer Grundvariante wird die modulare Ausgestaltung unterschiedlicher Schaltungsarten und Leistungsbereiche ermöglicht, wobei unterschiedliche Kühlsysteme angewendet werden können. Außerdem ist durch die Ausgestaltung die Stromrichtereinheit gewichts- und volumenreduziert.

Der Erfindung liegt nun die Aufgabe zugrunde, eine Stromrichtereinheit in Modulbauweise anzugeben, mit der eine durchgängige kostenminimierte Gerätereihe mit modularen Geräteaufbau, einheitlichem Gerätedesign, gleichen Schnittstellen und einheitlicher Schaltungstechnik über den gesamten Leistungsbereich erstellt werden kann.

Diese Aufgabe wird erfindungsgemäß mit den Merkmalen des Anspruchs 1 gelöst.

Dadurch, dass in einem Montagerahmen eine doppelseitig bestückbare Kühleinrichtung über eine Zwischenkreis-Kondensatorbatterie angeordnet ist, und die Leistungshalbleiter und die Zwischenkreis-Verschienung der Zwischenkreis-Kondensatorbatterie auf einer Seite des Montagerahmens angeordnet sind, wobei dieser Montagerahmen mittels mehrerer Abdeckbleche zu einem Luftkanal vervollständigt ist, erhält man eine kompakte Einheit, die zusammen mit weiteren Komponenten zu einem Stromrichtergerät verschaltet werden kann. Dieser Aufbau der Stromrichtereinheit wird über den gesamten Leistungsbereich einer Gerätereihe beibehalten. In Abhängigkeit der Leistung und der Stromrichtertopologie variiert nur die Anzahl der zu verwendeten Stromrichtereinheiten.

Bei einer vorteilhaften Ausführungsform der erfindungsgemäßen Stromrichtereinheit sind weitere Leistungshalbleiter vorgesehen, die auf der zweiten Montageplatte der doppelseitig bestückbaren Kühleinrichtung montiert sind, deren gleichspannungsseitige Anschlüsse mittels eines Verschienungsstückes mit der Zwischenkreis-Verschienung der Zwischenkreis-Kondensatorbatterie auf der gegenüberliegenden Seite des Montagerahmens verbunden sind. Außerdem sind diese weiteren Leistungshalbleiter ebenfalls mit einer korrespondierenden Ansteuerbaugruppe elektrisch leitend verbunden. Diese vorteilhafte Ausführungsform der erfindungsgemäßen Stromrichtereinheit weist somit alle Leistungsbauelemente eines Gleichspannungszwischenkreis-Umrichters auf kleinsten Raum auf. Im Kombination mit der zuvor genannten Stromrichtereinheit können nun alle Stromrichtertypen einer Gerätereihe für unterschiedliche Leistungsbereiche kompakt aufgebaut werden. Dadurch erhält man Stromrichtergeräte mit einem einheitlichen modularen Aufbau und Gerätedesign, wobei durch die erfindungsgemäße Stromrichtereinheit gleiche Schnittstellen und eine einheitliche Schaltungstechnik über einen gesamten Leistungsbereich gewährleistet wird.

Den Unteransprüchen 3 bis 9 sind vorteilhafte Ausgestaltungen der Stromrichtereinheit entnehmbar, mit denen eine endgültige Funktionsweise der Stromrichtereinheit zugeordnet wird.

Werden eine Stromrichtereinheit nach der Erfindung zusammen mit einer Lüftereinheit und einer Elektronikeinheit derart in einem Grundrahmen eingeschoben, dass die Lüftereinheit unterhalb der Stromrichtereinheit und die Elektronikeinheit neben dieser Stromrichtereinheit angeordnet sind, erhält man ein modular aufgebautes Stromrichtergerät. Wird eine vorteilhafte Ausführungsform der erfindungsgemäßen Stromrichtereinheit in diesen Grundrahmen geschoben, so erhält man als Stromrichtergerät ein sogenanntes Grundgerät.

Bei einem vorteilhaften Stromrichtergerät sind die Seiten und die Front des Grundgerätes mit Abdeckungen verkleidet und ist dieses Grundgerät oben und unten jeweils mit einem Netz- bzw. Motoranschluss versehen. Somit ist aus dem Grundgerät ein Einbaugerät entstanden.

Den Unteransprüchen 12 bis 16 sind die Kombinationsmöglichkeiten der Stromrichtereinheit und der vorteilhaften Stromrichtereinheit nach der Erfindung zu entnehmen. Allen gemeinsam ist, dass jeder Stromrichtereinheit eine Lüftereinheit und allen Stromrichtereinheiten eine Elektronikeinheit zugeordnet sind. Dadurch erhält man ein einheitliches Gerätedesign über den gesamten Leistungsbereich einer Gerätereihe.

Zur weiteren Erläuterung der Erfindung wird auf die Zeichnung Bezug genommen, in der mehrere Ausführungsformen der erfindungsgemäßen Stromrichtereinheit und des erfindungsgemäßen Stromrichtergerätes schematisch veranschaulicht sind.
- FIG 1: zeigt in einer Explosionsdarstellung eine erfindungsgemäße Stromrichtereinheit, wobei in der
- FIG 2: diese Stromrichtereinheit montiert dargestellt ist, in der
- FIG 3: ist in einer Explosionsdarstellung ein weiterer Teil einer Stromrichtereinheit 2 nach der Erfindung dargestellt, wogegen in der
- FIG 4: der zugehörige montierte Zustand veranschaulicht ist, die
- FIG 5: zeigt ein Stromrichtergerät mit einer Stromrichtereinheit nach FIG 2, wobei die
- FIG 6: dieses Stromrichtergerät im montierten Zustand zeigt, wobei in der
- FIG 7: ein zugehöriges Blockschaltbild dieses Stromrichtergerätes veranschaulicht ist, die
- FIG 8: zeigt ein Blockschaltbild eines weiteren Stromrichtergerätes, die
- FIG 9 und 10: zeigen jeweils eine Ansicht einer weiteren Stromrichtereinheit, wogegen in der
- FIG 11: ein zugehöriges Blockschaltbild dargestellt ist, und in den
- FIG 12 bis 15: sind verschiedene Kombinationsmöglichkeiten von Stromrichtereinheiten nach den FIG 2 und 9 dargestellt.

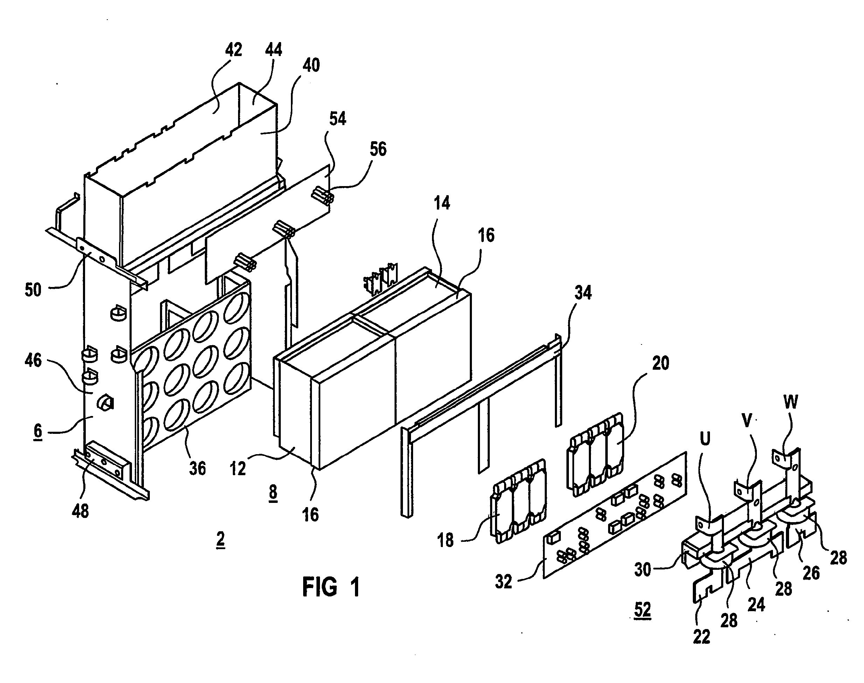

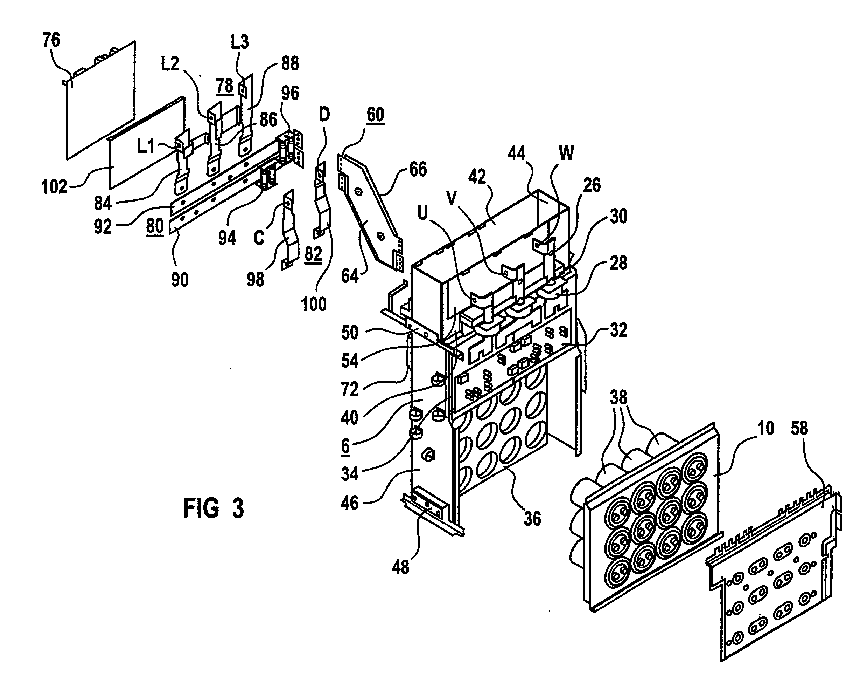

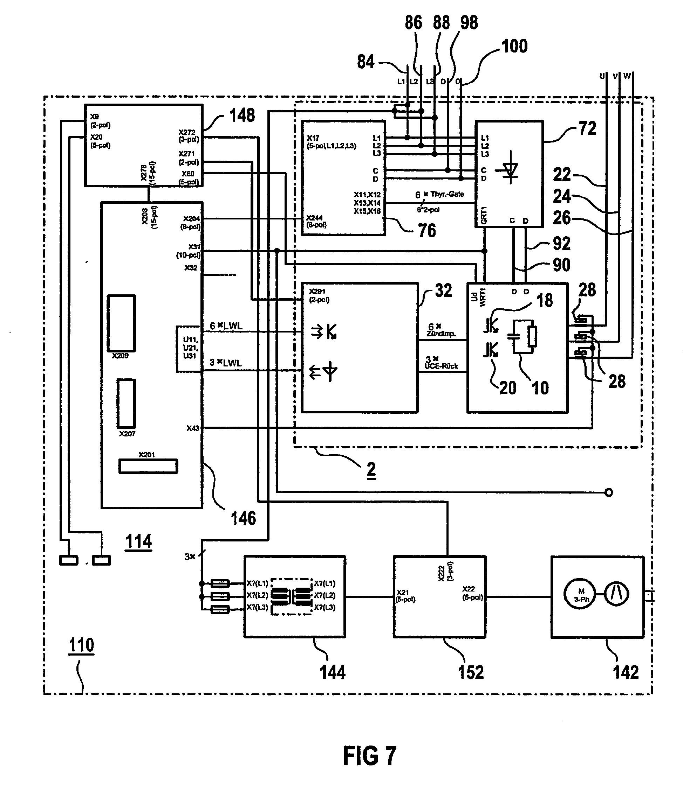

In der FIG 1 ist eine Explosionsdarstellung der Stromrichtereinheit 2 nach der Erfindung dargestellt, wobei in dieser Darstellung wegen der Übersichtlichkeit nur die Teile der Stromrichtereinheit 2 dargestellt sind, die auf der rechten Seite der Stromrichtereinheit 2 angeordnet sind. Die Bezeichnungen rechte Seite und linke Seite der Stromrichtereinheit 2 beziehen sich auf die Einschubrichtung dieser Stromrichtereinheit in einen Grundrahmen 4, der in der FIG 7 ersichtlich ist. Diese Stromrichtereinheit 2 weist als zentrale Einheit einen Montagerahmen 6 auf. Dieser Montagerahmen 6 nimmt einerseits eine Kühleinrichtung 8 und andererseits eine Zwischenkreis-Kondensatorbatterie 10 (FIG 3) auf, wobei die Kühleinrichtung 8 oberhalb der Kondensatorbatterie 10 angeordnet ist. Als Kühleinrichtung 8 sind hier zwei doppelseitig bestückbare Kühlkörper 12 und 14 vorgesehen. Auf jeder ersten Montageplatte 16 der beiden Kühlkörper 12 und 14 werden Leistungshalbleiter, insbesondere Leistungsmodule 18 und 20, montiert. Bei diesen beiden Leistungsmodulen 18 und 20 handelt es sich um IGBT-Sixpack-Module. Diese werden so miteinander verschaltet, dass diese eine 6-pulsigen Stromrichterbrücke bilden. Diese Verschaltung wird wechselspannungsseitig mittels Stromschienen 22, 24 und 26 bewerkstelligt, deren Stromschienenenden die Anschlüsse U, V und W bilden. Jede dieser Stromschienen 22, 24 und 26 ist mit einem Stromwandler 28 versehen, deren Signalleitung in einer Führungs- und Halteschiene 30 geführt werden. Auf den montierten Leistungsmodulen 18 und 20 ist eine Ansteuerbaugruppe 32 montiert. Diese Ansteuerbaugruppe 32 generiert aus zugeführten Steuersignalen für jeden Leistungshalbleiter einen Steuerstrom bzw. eine Steuerspannung. Außerdem beinhaltet diese Ansteuerbaugruppe 32 noch eine Entsättigungsüberwachung, die Rückmeldesignale generiert. Die Steuer- und Rückmeldesignale werden optisch übertragen, so-dass diese Ansteuerbaugruppe Teile der benötigten Optokoppler aufweist. Wegen dieser Entsättigungsüberwachung ist diese Ansteuerbaugruppe 32 nicht nur mit den Steuereingängen, sondern auch mit den wechselspannungsseitigen Anschlüssen der Leistungsmodule 28 elektrisch leitend verbunden. Außerdem ist auf den beiden Montageplatten 16 der beiden doppelseitig bestückbaren Kühlkörper 12 und 14 noch ein Hilfsmontagerahmen 34 montiert, der die beiden Kühlkörper 12 und 18 von mehreren Seiten umfasst. Dieser Hilfsmontagerahmen 34 dient bei der Montage der zuvor genannten Bauteile zu deren Fixierung und deren Abstützung.

Dieser Explosionszeichnung kann weiterhin eine Halterung 36 für Kondensatoren 38 der Zwischenkreis-Kondensatorbatterie 10 entnommen werden. Außerdem ist zu erkennen, dass der Montagerahmen 6 oberhalb der Kühleinrichtung 8 zwei seitliche Montagebleche 40 und 42 und zwei stirnseitige Bleche 44 und 46 aufweist, die diesen Teil zu einem Kühlmittelkanal ausbilden. Ferner weist der Montagerahmen 6 an seiner Frontseite 46 zwei Handhabungsmittel 48 und 50 auf, die jeweils unten und oben an der Frontseite 46 angebracht sind. Mit diesen Handhabungsmitteln 48 und 50 kann diese Stromrichtereinheit 2 in den bereits erwähnten und in der FIG 7 dargestellten Grundrahmen 4 gesteckt bzw. herausgezogen werden. Das seitliche Blech 40 dient nicht nur dazu, den oberen Teil des Montagerahmens 6 zu einem Kanal zu vervollständigen, sondern in erster Linie als Montageplatte des Stromschienensystems 52. Auf diesem Blech 40 wird zusätzlich eine weitere Platte 54 aus isolierenden Material montiert, die einerseits zur Potentialtrennung zwischen dem Montagerahmen 6 und den Stromschienen 22, 24 und 26 und andererseits zur Abstützung dieser Stromschienen 22, 24 und 26 dient. Dazu weist diese Platte 54 drei Distanzstücke 56 auf.

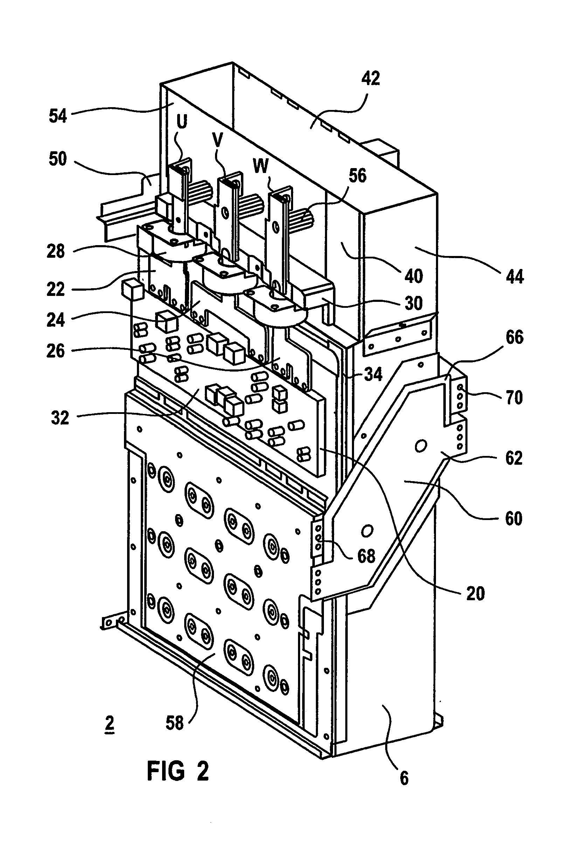

Die FIG 2 zeigt die Stromrichtereinheit 2 im montierten Zustand, und zwar von schräg hinten. In dieser Darstellung sind somit die rechte Seite und die Rückseite der Stromrichtereinheit 2 zu sehen. In dieser Darstellung sind zusätzlich Eine Zwischenkreis-Verschienung 58 und ein Verschienungsstück 60 sichtbar. Mittels der Zwischenkreis-Verschienung 50 sind die Kondensatoren 38 der Zwischenkreis-Kondensatorbatterie 10 elektrisch parallel und in Reihe geschaltet. Diese Zwischenkreis -Verschienung 50 ist derart ausgebildet, dass diese neben der Verschaltung der Kondensatoren 38 zusätzlich den unteren Teil des Montagerahmens 6 seitlich verschließt. Somit ist die rechte Seite des Montagerahmens 6 vollständig verschlossen. Das Verschienungsstück 60 ist auf der Rückseite der Stromrichtereinheit 2 angebracht und dient dazu, die beiden Potentiale der Zwischenkreis-Kondensatorbatterie 10 auf die linke Seite der Stromrichtereinheit zu führen. D.h., dieses Verschienungsstück 60 ist ein Verbindungselement zweier Leistungsteile der Stromrichtereinheit 2, die gemeinsam an der Zwischenkreis-Kondensatorbatterie 10 angeschlossen sind. Dieses Verschienungsstück 60 weist zwei parallele Stromschienen 62 und 64 auf, die mittels einer Isolierfolie 6-6 elektrisch voneinander isoliert sind. Wegen dieser Isolierfolie 66 sind von der Stromschiene 64 nur deren Anschlüsse 68 und 70 zu erkennen.

Die FIG 3 zeigt ebenfalls eine Explosionsdarstellung der Stromrichtereinheit 2, wobei die Teile der Explosionsdarstellung gemäß der FIG 1 hier im montierten Zustand veranschaulicht sind. In dieser Darstellung sind die Teile der Stromrichtereinheit 2 dargestellt, die auf der linken Seite dieser Stromrichtereinheit 2 angebracht sind. Zu diesen Teilen gehören Leistungshalbleiter 72, insbesondere Zweigmodule, die bereits auf der zweiten Montageplatte 74 der doppelseitig bestückbaren Kühleinrichtung 8 montiert sind. Zu diesen Leistungshalbleiter 72 gehört ebenfalls eine Ansteuerbaugruppe 76. Außerdem sind drei Stromschienensysteme 78, 80 und 82 dargestellt. Das Stromschienensystem 78 weist drei Stromschienen 84, 86 und 88 auf, die jeweils mit einem wechselspannungsseitigen Anschluss eines Zweigmoduls elektrisch leitend verbunden sind. Die freien Enden dieser Stromschienen 84, 86 und 88 bilden jeweils einen Anschluss L1, L2 und L3. Das Stromschienensystem 80 umfasst zwei parallel geführte Stromschienen 90 und 92, die jeweils einen gleichspannungsseitigen .Anschluss der Zweigmodule 72 miteinander verbinden. Aus diesem Grund verlaufen diese Stromschienen 90 und 92 waagerecht über die gesamte Tiefe der Stromrichtereinheit 2. Diese Stromschienen 90 und 92 sind jeweils mit einer Stromschiene 62 bzw. 64 des Verschienungsstücks 60 verknüpft. Außerdem ist jeder Stromschiene 90 und 92 jeweils mit einem Anschluss einer Widerstandsanordnung 94 und 96 elektrisch leitend verbunden. Die Widerstandsanordnung 94 und 96 besteht hier aus zwei elektrisch parallel geschalteten Widerständen, deren freien Enden jeweils mit einem Anschluss der Ansteuerbaugruppe 76 elektrisch leitend verbunden sind. Das dritte Stromschienensystem 82 weist ebenfalls zwei Stromschienen 98 und 100 auf, die jeweils mit einer Stromschiene 90 bzw. 92 des Stromschienensystems 80 elektrisch leitend verbunden sind. Die freien Enden dieser beiden Stromschienen 98 und 100 bilden einen Anschluss C und D. Damit werden die Potentiale der Zwischenkreis-Kondensatorbatterie 10 aus der Stromrichtreinheit 2 herausgeführt, an dem beispielsweise ein Chopperwiderstand anschließbar ist. Auch auf der linken Seite der Stromrichtereinheit 2 ist zur Potentialtrennung zwischen dem Montagerahmen 6 und dem Stromschienensystem 78 und 89 eine Platte 102 aus isolierenden Material zur Potentialtrennung zwischen dem Montagerahmen 6 und den Stromschienen 84, 86, 88 und 98, 100 und zur Abstützung dieser Stromschienen 84 bis 100 angebracht.

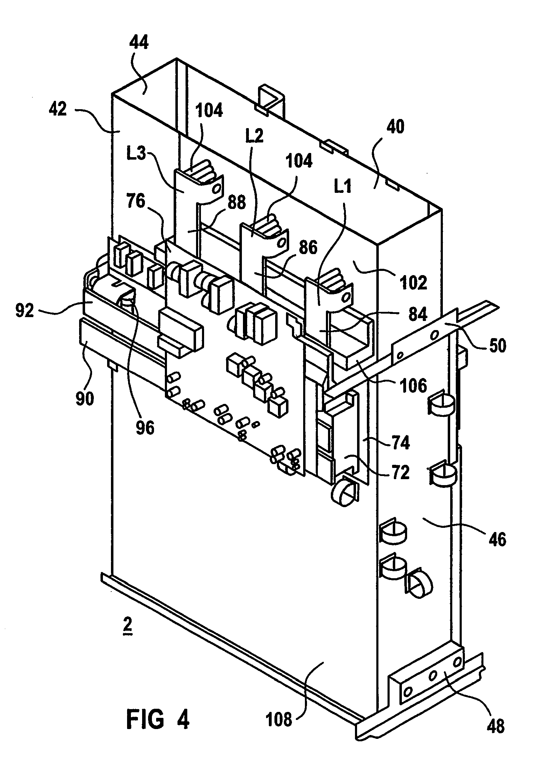

In der FIG 4 ist die montierte linke Seite der Stromrichtereinheit 2 dargestellt. Dieser Darstellung kann entnommen werden, dass die Platte 102 ebenfalls Distanzstücke 104 aufweist, mit denen die freien Enden der Stromschienen 84, 86 und 88 fixiert werden. Neben diesen Distanzstücken 104 ist auch noch eine Montagehilfe 106 vorgesehen. Ferner weist der untere Teil der Stromrichtereinheit 2 eine Abdeckplatte 108 auf, mit der der Bereich der Zwischenkreis-Kondensatorbatterie verschlossen ist. Damit ist der Montagerahmen 6 zu einem Kühlmittelkanal vervollständigt worden.

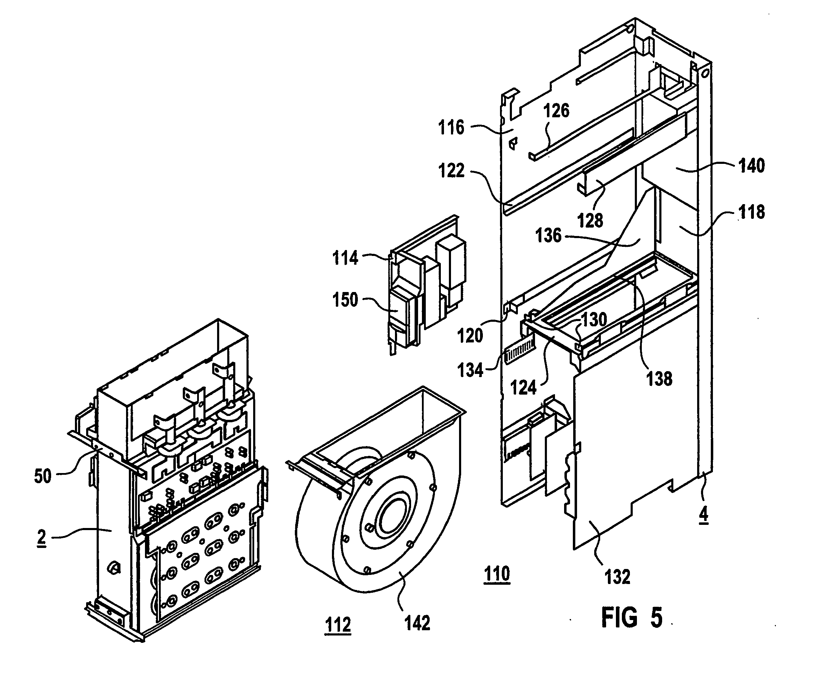

Die FIG 5 zeigt ein Stromrichtergerät 110 in einer Explosionsdarstellung, das aus einer Stromrichtereinheit 2 gemäß FIG 2, einer Lüftereinheit 112 von dem aus übersichtlichkeitsgründen nur der Lüfter 142 dargestellt ist, einer Elektronikeinheit 114 und einem Grundrahmen 4 besteht. In diesem Grundrahmen 4 sind diese Teile 2, 142 und 114 eingeschoben. Dazu weist dieser Grundrahmen 4 verschiedene Führungsschienen auf. Der Grundrahmen 4 besteht aus einer Seitenwand 116 und einer Rückwand 118, die miteinander rechtwinklig verbunden sind. Ferner ist diese Rückwand 118 mit einer rechtwinkligen Montageleiste versehen. Diese Seitenwand 116 weist an seiner Innenseite zwei Führungsschienen 120 und 122 auf, die zur Aufnahme des Lüfters 142 der Elektronikeinheit 114 beabstandet zueinander angeordnet sind. An der Rückwand 118 dieses Grundrahmens 4 sind einerseits ein Tragrahmen 124 und andererseits zwei Verriegelungsstreben 126 und 128 angeordnet, wobei die Strebe 128 als Blende ausgeführt ist. Der Tragrahmen 124 weist auf seiner Unterseite zwei seitliche Führungsnuten zur Aufnahme des Lüfters 142 der Lüftereinheit 112 auf, wogegen auf seiner Oberseite frontseitig zwei Anschlagbleche 130 vorhanden sind. Außerdem wird dieser Tragrahmen 124 einseitig mittels eines Seitenblechs 132 über seine gesamte Tiefe abgestützt, wobei die andere Seite nur mittels einer Stütze 134 abgestützt wird. Zur Befestigung des Tragrahmens 124 an der Rückwand 118 des Grundrahmens 4 weist dieser Tragrahmen 124 einen Befestigungsflansch 136 auf, der über die gesamte Tiefe des Tragrahmens 124 mit dem linken Holm 138 des Tragrahmens 124 verbunden ist. Dieser Befestigungsflansch 136 unterstützt gleichzeitig die Führung der Stromrichtereinheit 2 beim Einschieben dieser Stromrichtereinheit 2. Damit das Handhabungsmittel 50 der Stromrichtereinheit 2 im eingeschobenen Zustand eine frontseitige Querstrebe bilden kann, ist die Rückwand 118 im Steckbereich der Stromrichtereinheit 2 mit einem Distanzstück 140 versehen.

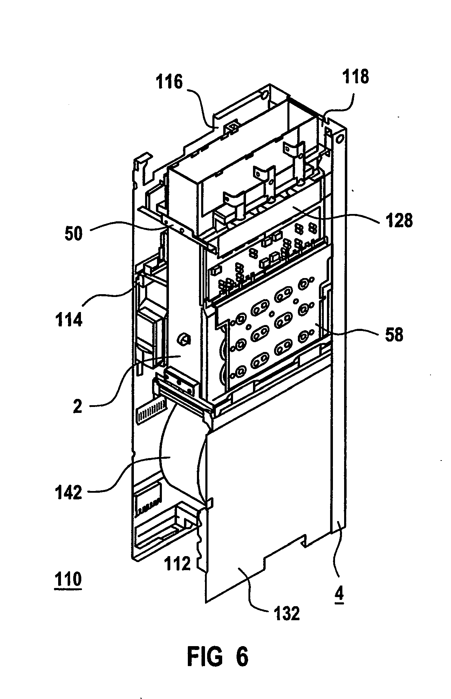

In der FIG 6 ist das Stromrichtergerät 110 im montierten Zustand dargestellt. Dieser Darstellung ist zu entnehmen, dass der Lüfter 142 der Lüftereinheit 112 direkt unter der Stromrichtereinheit 2 eingeschoben ist, wobei die Elektronikeinheit 114 neben dieser Stromrichtereinheit 2 eingeschoben ist. Weitere Teile der Lüftereinheit 112 werden in dem Bereich unterhalb des Lüfters 142 platziert. In diesem montierten Zustand bilden das Seitenblech 132 und die Zwischenkreis-Verschienung 58 der Stromrichtereinheit 2 eine teilweise Abdeckung des Stromrichtergerätes 110 nach rechts. Nach links und nach hinten ist das Stromrichtergerät 110 mittels der Seitenwand 116 und der Rückwand 118 verschlossen. Aus diesem Grund besteht nur zwischen der Stromrichtereinheit 2 und der Seitenwand 116 genügend Platz für die Aufnahme der Elektronikeinheit 114. An dieser Stelle ist die Elektronikeinheit 114 seitwärts von zwei Blechen, nämlich der Seitenwand 116 des Stromrichtergerätes 110 und der Abdeckplatte 108 der Stromrichtereinheit 2 eingerahmt, die damit diese Elektronikeinheit 114 abschirmen. Die Lüftereinheit 112 weist neben den Lüfter 142 auch noch einen Lüftertransformator 144 mit seinen Sicherungen auf. Damit der Lüfter 142 mit seiner Versorgungsspannung bei verschiedenen Spannungsklassen betrieben werden kann, ist als Lüftertransformator 144 ein Transformator mit mehreren primärseitigen Anzapfungen erforderlich. Aus Kostengründen wird ein AC-Lüfter anstelle eines DC-Lüfters verwendet. Wegen der verwendeten doppelseitig bestückbaren Kühlkörper 12 und 14 ist beispielsweise ein relativ druckstarker Lüfter 142 erforderlich. Dieser Lüfter 142 kann als Radiallüfter oder als Trommelläufer ausgebildet sein. Damit eine Forderung nach möglichst geringen Schalldruckpegel auch eingehalten werden kann, wird als Lüfter ein vierpoliger Lüfter 142 verwendet. Ein derartiger Lüfter hat beispielsweise eine Drehzahl von etwa 1400 1/min. Vorteilhafter Weise wird als AC-Lüfter ein Drehstromlüfter vorgesehen, wodurch die Drehzahl des Lüfters bei 60Hz Betrieb auf dem Niveau von 50Hz gehalten werden kann. Dadurch ist die Geräuschemission in beiden Betriebspunkten gleich. Bei 1-phasigen Lüftern ist dies nicht möglich, da die dabei anfallende Verlustleistung überproportional groß wird und damit teure Motoren zur Folge haben.

Die Elektronikeinheit 114 umfasst eine Interface-Baugruppe 146, eine Regelungsbaugruppe, eine Stromversorgungsbaugruppe 148 und eine Bedieneinheit 150. Die Regelungsbaugruppe umfasst eine feldorientierte Regelung und einen pulsweiten Modulator, an dessen Ausgängen die Steuersignale anstehen. Die Interface-Baugruppe 146 ist als Identifizierungskarte bzw. als Ausweiskarte der Stromrichtereinheit 2 ausgestaltet, wodurch die Regelungsbaugruppe erfährt, welche Leistungsteile in der Stromrichtereinheit 2 angeordnet sind. Somit gehört diese Interface-Baugruppe 146 zur Stromrichtereinheit 2, die wegen Trennung von Signalelektronik und Leistungselektronik in der Elektronikeinheit 114 untergebracht ist.

In der FIG 7 ist ein Blockschaltbild des Stromrichtergerätes 110 nach der FIG 6 näher dargestellt. Dieses Blockschaltbild weist ein weiteres Blockschaltbild der Stromrichtereinheit 2 auf, das wegen seiner Ausgestaltung auch als Powerblock bezeichnet wird. Bei dem in der FIG 6 dargestellten Stromrichtergerät 110 handelt es sich um ein Grundgerät. In diesem Blockschaltbild des Stromrichtergerätes 110 ist von der Elektronikeinheit 114 nur die Interface-Baugruppe 146 und die Stromversorgungsbaugruppe 148 dargestellt. Zur Lüftereinheit 112 gehört neben dem Lüfter 142 und dem Lüftertransfo-rmator 144 auch noch eine Lüfterelektronikbaugruppe 152. Diese Lüfterelektronikbaugruppe 152 überprüft das Drehfeld der Lüfterversorgungsspannung auf der Sekundärseite des Lüftertransformators 144. Wenn bei der Aufstellung des Stromrichtergerätes 110 kein Rechts-Drehfeld angeschlossen worden ist, wird auf der Lüfterelektronikbaugruppe 152 eine Phasendrehung durchgeführt. Diese Phasendrehung findet während des Einschaltvorgangs nach dem Hochlauf der Stromversorgungsbaugruppe 148, bei nicht eingeschaltetem Lüfter 142, statt. Außerdem befindet sich auf dieser Lüftere3ektronikbaugruppe 152 Lüfterrelais zum Ein- und Ausschalten des Lüfters 142. Versorgt wird diese Lüfterelektronikbaugruppe 152 von der Stromversorgungsbaugruppe 148. Diese Lüfterelektronikbaugruppe 152 wird im Bereich des Lüftertransformators 140 angeordnet, der sich unter dem Lüfter 142 befindet. Da in diesem Bereich mit einer erhöhten Verschmutzung zu rechnen ist, ist diese Lüfterelektronikbaugruppe 152 für einen Verschmutzungsgrad 3 ausgelegt.

Dem Blockschaltbild der Stromrichtereinheit 2 ist zu entnehmen, dass diese einen Gleichrichter und einen Wechselrichter aufweist, die gleichspannungsseitig mittels der Zwischenkreis-Kondensatorbatterie 10 miteinander verknüpft sind. Da diese Zwischenkreis-Kondensatorbatterie 10 aus mehreren Kondensatoren 38 aufgebaut ist, weist diese Kondensatorbatterie 10 auch noch Symmetrierungs-Widerstände auf, die hier durch ein elektrisches Ersatzschaltbild veranschaulicht sind. Der Gleichrichter besteht aus einer vollgesteuerten Thyristorbrücke in B6-Schaltung. Die Ansteuerung der Thyristoren erfolgt über die Ansteuerbaugruppe 76. Diese Ansteuerbaugruppe 76 dient der Vorladung der Zwischenkreis-Kondensatorbatterie 10 und zur Erzeugung von Zündimpulsen für die Thyristoren bei AC/AC-Geräten. Ferner wurde in dieser Ansteuerbaugruppe eine Netzüberspannungsschutzschaltung integriert. Diese soll das Stromrichtergerät 110 gegen kurze Überspannungspieks schützen. Weiterhin ist in dieser Ansteuerbaugruppe 76 die Grundentstörung integriert. D.h., die Masseverbindung dieses Schaltungsteils kann bei Betrieb in internationalen Netzen leicht, durch Lösen einer von vorn zugänglichen Schraube, entfernt werden.

Auf dieser Ansteuerbaugruppe 76 befinden sich neben sechs Ansteuerungen für die Thyristoren auch ein Hilfsgleichrichter für die Vorladung der Zwischenkreis-Kondensatorbatterie 10. Außerdem ist auf dieser Baugruppe 76 eine Schaltung zur Phasenausfallerkennung der Netzspannung vorhanden. Bei Fehlen einer Netzphase erhält die Steuerelektronik über die Interface-Baugruppe 146 ein Fehlersignal. Die Ansteuerungen für die Thyristoren erhalten von einem Modulator der Regelungsbaugruppe über die Interface-Baugruppe 146 ein Freigabesignal. Die Ansteuerung sorgt dafür, dass die Thyristoren jeweils zum natürlichen Zündzeitpunkt gezündet werden. Der Thyristorgleichrichter wirkt dann praktisch wie ein umgesteuerter Gleichrichter.

Mit der vollgesteuerten Brücke ergibt sich die Möglichkeit eine ausgangsseitige Erdschlussfestigkeit auch beim Zuschalten des Gerätes zu erreichen. Bei einer halbgesteuerten Gleichrichter-Brücke könnte sich ein Erdschluss über die Netzdioden, den Zwischenkreis und die Freilaufdioden im Wechselrichter schließen. Durch Wegschalten des Freigabesignals wird der Hauptstrompfad gesperrt und der Strom durch die Vorladewiderstände begrenzt. Voraussetzung hierfür ist eine Kontrolle der Ausgangsströme auf nicht Vorhandensein im Standby-Betrieb. Mit dem Wegschalten des Freigabesignals muss zum Schutz der Vorladewiderstände eine Störmeldung abgesetzt und das Gerät spannungsfrei geschaltet werden.

Da der Gleichrichter stets mit α = 0° betrieben wird, ist eine herkömmliche TSE-Beschaltung nicht erforderlich. Da die Zwischenkreis-Kondensatorbatterie 10 induktivitätsarm mit dem Gleichrichter 72 verbunden ist, d.h., im Spannungszwischenkreis sind keine Drosseln angeordnet, wirkt diese spannungsbegrenzend. Die Funktion einer Beschaltung wird durch die Vorladewiderstände in Verbindung mit dem Vorladegleichrichter und dem hierzu parallel geschalteten Kondensator übernommen.

Die mechanische Größe des Montageraums 6 wird durch die eingesetzten Leistungsmodule, insbesondere IGBT-Module, im Wechselrichter bestimmt. Vorteilhafter Weise werden IGBT-Module in der Bauform Six-Pack verwendet. Ein derartiges Modul zeichnet sich durch seine kostengünstige Aufbauform und durch die Six-Pack-Anordnung der einzelnen Schalter aus. Der Wechselrichter kann mit einem, zwei oder drei Six-Packs aufgebaut werden. Wird nur ein Six-Pack verwendet, so besitzt der Wechselrichter nur eine Ansteuerung. Werden zwei Six-Packs verwendet, die gleichspannungsseitig elektrisch parallel geschaltet sind, werden die drei Phasen U, V und W des Wechselrichters gebildet. Die zugehörige Ansteuerbaugruppe 32 verbindet beide Module 18 und 20. Werden drei Six-Packs gleichspannungsseitig parallel geschaltet, bildet jedes Six-Packs-Modul ein Phasenmodul des Wechselrichters. Jedes Phasenmodul weist eine eigene Ansteuerung auf, die jeweils auf einer Ansteuerbaugruppe bzw. auf einer einzigen Ansteuerbaugruppe 32 integriert sind.

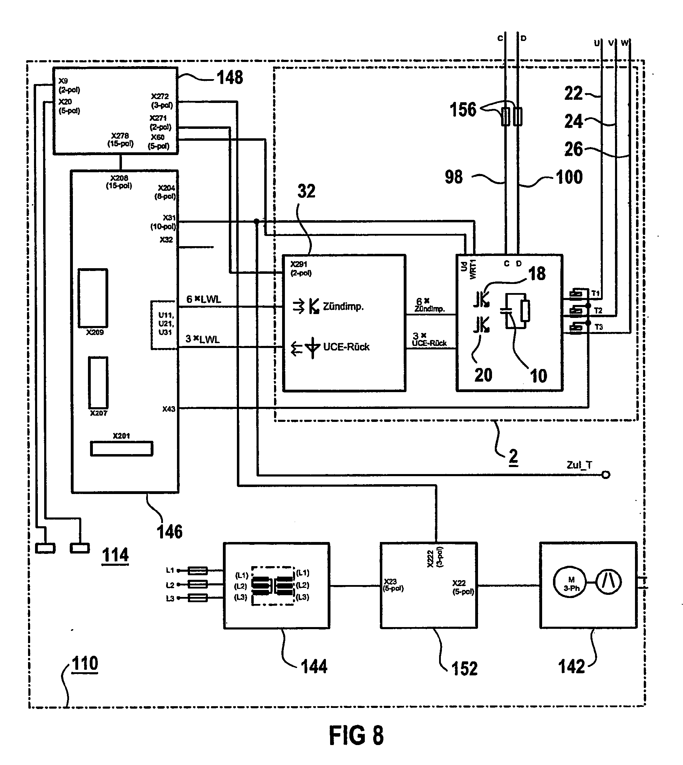

In der FIG 8 ist ebenfalls ein Blockschaltbild eines Stromrichtergerätes 110 dargestellt, das sich vom Blockschaltbild nach FIG 7 dadurch unterscheidet, dass im Blockschaltbild der Stromrichtereinheit 2 kein Gleichrichter mit zugehöriger Ansteuerbaugruppe 76 mehr vorhanden ist. Bei diesem Grundgerät handelt es sich um ein Wechselrichtergerät. Derartige Wechselrichtergeräte werden beispielsweise bei einem Mehrmotoren-Antriebssystem verwendet, wobei jeder Motor von einem Wechselrichtergerät gespeist wird und alle Wechselrichtergeräte aus einer gemeinsamen Gleichspannungsversorgung versorgt werden. Die zugehörige Stromrichtereinheit 2 unterscheidet sich von der Stromrichtereinheit 2 des Stromrichtergerätes 110 nach FIG 7 dadurch, dass auf der linken Seite des bzw. der Kühlkörper 12 und 14 keine Leistungshalbleiter 72 montiert sind. Dadurch entfallen auch alle Teile dieser linken Seite, die in der Explosionsdarstellung gemäß FIG 3 veranschaulicht sind. Damit diese Stromrichtereinheit 2 an einer Gleichspannungsversorgung angeschlossen werden kann, müssen die beiden Gleichspannungspotentiale der Zwischenkreis-Kondensatorbatterie 10 mittels der Stromschienen 98 und 100 aus der Stromrichtereinheit 2 herausgeführt werden. Ansonsten besteht kein Unterschied zwischen diesen beiden Stromrichtergeräten 110 nach den FIG 7 und 8.

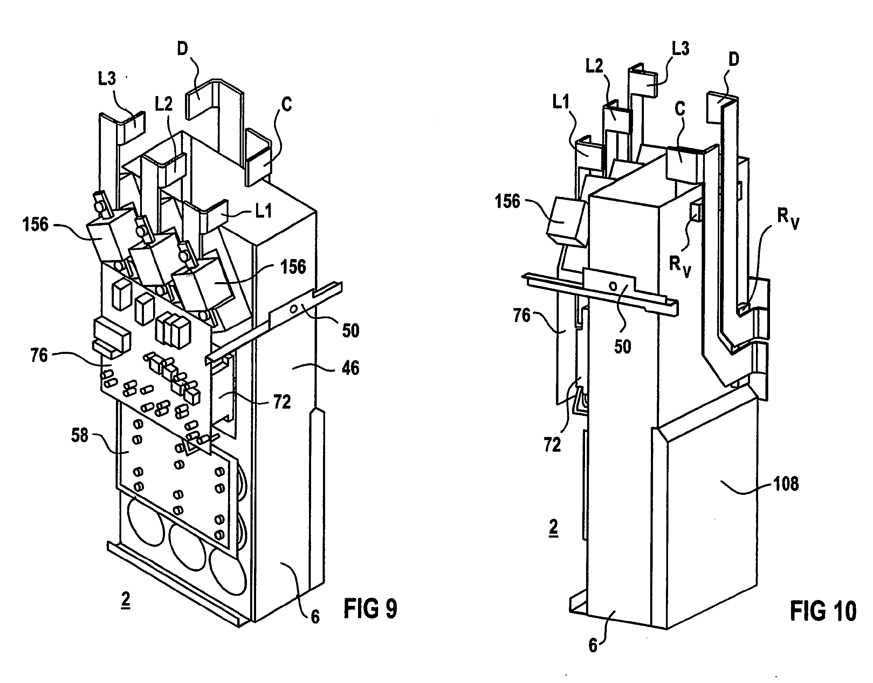

In den FIG 9 und 10 sind eine und dieselbe Stromrichtereinheit 2 mit Blick auf die linke und auf die rechte Seite dieser Stromrichtereinheit 2 dargestellt. Bei dieser Stromrichtereinheit 2 handelt es sich um einen Gleichrichter, der in den zuvor beschriebenen Powerblock-Konzept aufgebaut ist. Das Powerblock-Konzept ist dadurch gekennzeichnet, dass in einem Montagerahmen 6 eine Kühleinrichtung 8 und darunter eine Zwischenkreis-Kondensatorbatterie 10 angeordnet sind. Durch die Funktion der Stromrichtereinheit 2 als Gleichrichter sind bei dieser Stromrichtereinheit 2 neben den Leistungshalbleitern 72, der Ansteuerbaugruppe 76, der Zwischenkreis-Verschienung 58 der Zwischenkreis-Kondensatorbatterie 10 noch Halbleitersicherungen 156 angeordnet. Außerdem ist die Zwischenkreis-Kondensatorbatterie 10 nicht auf der rechten Seite, sondern auf der linken Seite dieser Stromrichtereinheit 2 eingeschoben. Die Vorladewiderstände Rᵥ sind bei dieser Ausführungsform der Stromrichtereinheit 2 auf der rechten Seite auf der Abdeckplatte 108 angeordnet, die bei dieser Stromrichtereinheit 2 die gesamte rechte Seite des Montagerahmens 6 verschließt.

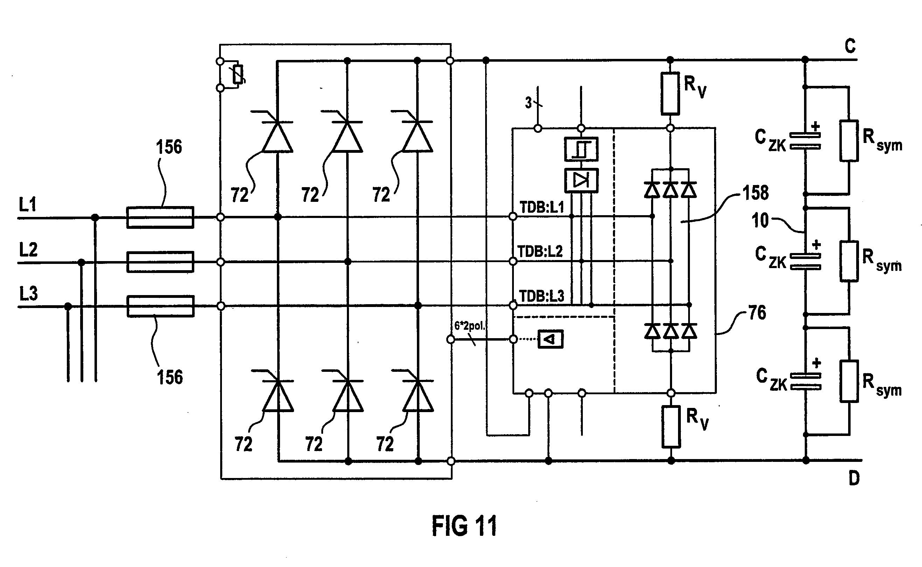

Gemäß dem Blockschaltbild dieser Stromrichtereinheit 2 nach FIG 11 ist der Gleichrichter als eine Sechspuls-Drehstrombrückenschaltung aufgebaut. Soweit möglich werden Thyristormodule eingesetzt, wogegen bei größeren Leistungen Diodenmodule verwendet werden. Thyristorgleichrichter haben den Vorteil, dass sie kein Hauptschütz und beim Spannungshochlauf keine Hilfsstromversorgung benötigen. Sie sind daher kostengünstiger als ein Diodengleichrichter mit Hauptschütz. Zur Ansteuerung der Thyristoren wird die Ansteuerbaugruppe 76 verwendet auf der noch ein Hilfsgleichrichter 158 für die Vorladung untergebracht ist. Die Vorladung der Zwischenkreis-Kondensatorbatterie 10 geschieht über je ein Widerstand Rᵥ im Plus- und im Minuszweig der Zwischenkreis-Kondensatorbatterie 10. Der Hilfsgleichrichter 158 (B6-Diodenbrücke) auf der Ansteuerbaugruppe 76 speist die Zwischenkreis-Kondensatorbatterie 10 aus dem Netz über die Vorladewiderstände Rᵥ. Die Vorladeschaltung ist so dimensioniert, dass eine Zwischenkreis-Gesamtkapazität C_{ZK} in Höhe der 4-fachen Gleichrichter-Zwischenkreis-Kapazität geladen werden kann. Zusätzlich fließt auch noch der Strom, der durch die Symmetriewiderstände R_{sym} verursacht wird, über den Vorladekreis. Die Vorladewiderstände Rᵥ sind für eine Vorladezeit von beispielsweise 3,5 sec ausgelegt. Dabei wird angenommen, dass sich die Zwischenkreis-Kondensatorbatterie 10 in diesen Zeitraum auf 95 % des Netzspannungsscheitelwertes auflädt.

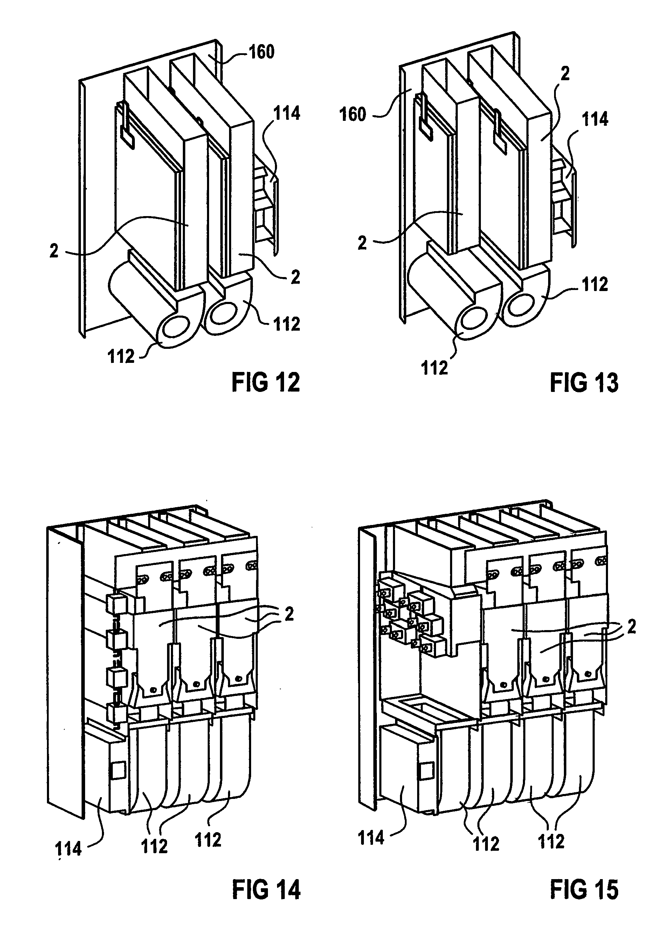

In den FIG 12 bis 15 sind mehrere Kombinationen von Stromrichtereinheiten 2 dargestellt. Gemäß der FIG 12 sind zwei Stromrichtereinheiten 2 mit zugehörigen Lüftereinheiten 112 und einer Elektronikeinheit 114 in einem Rahmen, von dem aus Übersichtlichkeitsgründen nur die Rückwand 160 dargestellt ist, angeordnet. Eine Stromrichtereinheit 2 enthält einen Gleichrichter und eine Phase eines Wechselrichters, wobei die zweite Stromrichtereinheit 2 zwei weitere Phasen des Wechselrichters aufweist. Somit stellt diese Kombination der beiden Powerblöcke 2 eine AC/AC-Stromrichteranordnung dar.

In der FIG 13 sind ebenfalls zwei Stromrichtereinheiten 2 zusammen mit korrespondierenden Lüftereinheiten 112 und einer Elektronikeinheit 114 an einer Rückwand 160 angeordnet. Bei dieser Anordnung weist der rechte Powerblock 2 zwei Phasen eines Wechselrichters auf, wogegen die dritte Phase dieses Wechselrichters vom linken Powerblock 2 realisiert ist. Somit stellt diese Kombination zweier Powerblöcke 2 eine DC/AC-Stromrichteranordnung dar.

Bei größeren Leistungen wird jede Wechselrichterphase durch einen Powerblock 2 realisiert. Damit man eine DC/AC-Stromrichteranordnung erhält, müssen drei Powerblöcke 2 und eine Elektronikeinheit 114 gemeinsam an einer Rückwand 160 gemäß FIG 14 nebeneinander angeordnet werden. Dabei weist jeder Powerblock 2 eine Lüftereinheit 112 auf.

Soll diese DC/AC-Stromrichteranordnung zu einer AC-AC-Stromrichteranordnung erweitert werden, so muss nur ein weiterer Powerblock 2 hinzugefügt werden. Dieser Powerblock 2 ist dann gemäß FIG 9 ausgebildet. In der FIG 15 ist der weitere Powerblock 2 (Gleichrichter) nicht vollständig dargestellt. Auch hier weist jeder Powerblock 2 eine eigene Lüftereinheit 112 auf.

Die dargestellten Kombinationsmöglichkeiten stellen keine abschließende Aufzählung dar. Die Anzahl der zu kombinierenden Stromrichtereinheit 2, hängt von der Leistung der zu erstellenden Stromrichteranordnung und von deren Ausführungsform (Umrichter, Wechselrichter, Mehrmotoren-Antriebssystem) ab. Unabhängig von der Anzahl der zu kombinierenden Powerblöcke 2 wird jedoch bei allen Powerblöcken 2 dieselbe Kühleinrichtung verwendet.

Durch die erfindungsgemäße Ausgestaltung der Stromrichtereinheit 2 im Zusammenhang mit der der Stromrichtereinheit 2 zugeordneten Lüftereinheit 112 kann eine durchgängige kostenminimierte Gerätereihe über einen weiten Leistungsbereich aufgebaut werden, wobei jedes Gerät modular aufgebaut ist.

Anstelle der Luftkühlung kann auch eine Wasserkühlung vorgesehen sein, wodurch sich am Prinzip Powerblock 2 bzw. Kombination mehrerer Powerblöcke 2 nichts ändert. Bei der Umstellung von Luftkühlung auf Wasserkühlung werden ebenfalls die Kondensatoren 38 der Zwischenkreis-Kondensatorbatterie 10 mit Wasser gekühlt. Eine Ausführungsform einer derartigen Kondensatorkühlung ist in der nationalen Patentanmeldung mit dem internen Aktenzeichen 2001P19990 DE näher beschrieben. Ein besonders vorteilhafter Kühlkörper, deren Kühlrippen hinsichtlich des Gegendrucks optimiert sind, ist in der nationalen Patentanmeldung mit dem internen Aktenzeichen 2001P19991 DE beschrieben.

## Patentansprüche

1. Stromrichtereinheit (2) in Modulbauweise mit einem Montagerahmen (6), der eine doppelseitig bestückbare Kühleinrichtung (8) und eine aus mehreren Kondensatoren (38) bestehende Zwischenkreis-Kondensatorbatterie (10) aufweist, wobei diese Kühleinrichtung (8) oberhalb der Zwischenkreis-Kondensatorbatterie (10) im Montagerahmen (6) angeordnet ist, mit Leistungshalbleiter (18,20), die auf einer ersten Montageplatte (16) der doppelseitig bestückbaren Kühleinrichtung (8) montiert sind, und deren Steueranschlüsse mit einer Ansteuerbaugruppe (32) verknüpft sind, mit einer Zwischenkreis-Verschienung (58), die die Kondensatoren (38) der Zwischenkreis-Kondensatorbatterie (10) untereinander und mit gleichspannungsseitigen Anschlüssen der Leistungshalbleiter (18,20) elektrisch leitend verbindet, mit Stromschienen (22,24,26), die jeweils mit einem wechselspannungsseitigen Anschluss der Leistungshalbleiter (18,20) elektrisch leitend verbunden sind, und mit mehreren Abdeckblechen (40,42,44,46,102,108), mit denen der bestückte Montagerahmen (6) derart verkleidet wird, dass ein Luftkanal entsteht.

2. Stromrichtereinheit (2) nach Anspruch 1, **dadurch gekennzeichnet, dass** weitere Leistungshalbleiter (72) vorgesehen sind, die auf der zweiten Montageplatte (74) der doppelseitig bestückbaren Kühleinrichtung (8) montiert sind, und deren Steueranschlüsse mit einer weiteren Ansteuerbaugruppe (76) verknüpft sind und mit Stromschienen (84,86,88,90,92), die jeweils mit wechselspannungs- und gleichspannungsseitigen Anschlüssen der Leistungshalbleiter (72) elektrisch leitend verbunden sind, und mit einem Verschienungsstück (60), das die gleichspannungsseitigen Anschlüsse der weiteren Leistungshalbleiter (72) mit der Zwischenkreis-Verschienung (58) der Zwischenkreis-Kondensatorplatte (10) auf der gegenüberliegenden Seite des Montagerahmens (6) elektrisch leitend verbindet.

3. Stromrichtereinheit (2) nach Anspruch 1, **dadurch gekennzeichnet, dass** die Stromschienen (22,24,26) jeweils einen Stromsensor (28) aufweisen.

4. Stromrichtereinheit (2) nach Anspruch 1 oder 2, **dadurch gekennzeichnet, dass** zwischen den wechselspannungsseitigen Anschlüssen der Leistungshalbleiter (18,20,72) und den Stromschienen (22,24,26,84,86,88) jeweils Halbleitersicherungen (156) angeordnet sind, und dass Vorladewiderstände (Rᵥ) vorgesehen sind, die auf einer Montageplatte (16) der doppelseitig bestückbaren Kühleinrichtung (8) montiert sind, und die einerseits mit einem gleichspannungsseitigen Anschluss der Zwischenkreis-Kondensatorbatterie (10) und andererseits mit einem Anschluss der Ansteuerbaugruppe (32,76) verknüpft sind.

5. Stromrichtereinheit (2) nach Anspruch 1, **dadurch gekennzeichnet, dass** als Leistungshalbleiter (18,20) wenigstens ein Six-Pack-Modul vorgesehen sind.

6. Stromrichtereinheit (2) nach Anspruch 1 oder 2, **dadurch gekennzeichnet, dass** als Leistungshalbleiter (72) Thyristoren vorgesehen sind.

7. Stromrichtereinheit (2) nach einem der vorgenannten Ansprüche, **dadurch gekennzeichnet, dass** die Kühleinrichtung (8) luftgekühlt ausgeführt ist.

8. Stromrichtereinheit (2) nach einem der Ansprüche 1 bis 6, **dadurch gekennzeichnet, dass** die Kühleinrichtung (8) flüssigkeitsgekühlt ausgebildet ist.

9. Stromrichtereinheit (2) nach Anspruch 8, **dadurch gekennzeichnet, dass** die flüssigkeitsgekühlte Kühleinrichtung (8) derart ausgebildet ist, dass die Kondensatoren (38) der Zwischenkreis-Kondensatorbatterie (10) flüssigkeitsgekühlt sind.

10. Stromrichtergerät (110) mit einer Stromrichtereinheit (2) nach den Ansprüchen 1 und 2, **dadurch** gekenn-zeichnet, dass diese Stromrichtereinheit (2) in -einen Grundrahmen (4) eingeschoben ist, und dass in diesem Grundrahmen (4) eine Lüftereinheit (112) und eine Elektronikeinheit (114) eingeschoben sind, wobei die Lüftereinheit (112) unterhalb und die Elektronikeinheit (114) neben der Stromrichtereinheit (2) angeordnet sind.

11. Stromrichtergerät (110) nach Anspruch 10, **dadurch gekennzeichnet, dass** die Seiten und die Front des Stromrichtergerätes (110) mit Abdeckungen verschlossen sind, und das dieses Stromrichtergerät (110) mit einem Netz- und einem Motoranschluss versehen ist, die oben und unten am Gerät angebracht sind.

12. Stromrichtergerät (110) mit einer Stromrichtereinheit (2) nach den Ansprüchen 1 und 2 und mit einer Stromrichtereinheit (2) nach Anspruch 1, **dadurch** gekennzeich-net, dass diese beiden Stromrichtereinheiten (2) nebeneinander in einem Grundrahmen (4) eingeschoben sind und dass unterhalb jeder Stromrichtereinheit (2) eine Lüftereinheit (112) eingeschoben ist, und dass neben diesen benachbarten Stromrichtereinheiten (2) eine Elektronikeinheit (114) in diesem Grundrahmen (4) eingeschoben ist.

13. Stromrichtergerät (110) mit zwei Stromrichtereinheiten (2) nach Anspruch 1, **dadurch gekennzeichnet, dass** diese beiden Stromrichtereinheiten (2) nebeneinander in einen Grundrahmen (4) eingeschoben sind, dass unterhalb jeder Stromrichtereinheit (2) eine Lüftereinheit (112) eingeschoben ist, und dass neben diesen benachbarten Stromrichtereinheiten (2) eine Elektronikeinheit (114) in diesem Grundrahmen (4) eingeschoben ist.

14. Stromrichtergerät (110) mit drei Stromrichtereinheiten (2) nach Anspruch 1, **dadurch** gekennzeich-net, dass diese drei Stromrichtereinheiten (2) nebeneinander in einen Grundrahmen (4) eingeschoben sind, dass unterhalb jeder Stromrichtereinheit (2) eine Lüftereinheit (112) eingeschoben ist, und dass neben diesen benachbarten Stromrichtereinheiten (2) eine Elektronikeinheit (112) in diesem Grundrahmen (4) eingeschoben ist.

15. Stromrichtergerät (110) mit vier Stromrichtereinheiten (2) nach Anspruch 1, **dadurch** gekennzeich-net, dass diese Stromrichtereinheiten (2) nebeneinander in einen Grundrahmen (4) eingeschoben sind, dass unterhalb jeder Stromrichtereinheit (2) eine Lüftereinheit (112) eingeschoben ist, und dass neben diesen benachbarten Stromrichtereinheiten (2) eine Elektronikeinheit (114) in diesem Grundrahmen (4) eingeschoben ist.

16. Stromrichtergerät (110) nach einem der Ansprüche 10 bis 15, **dadurch gekennzeichnet, dass** die Elektronikeinheit (2) wenigstens eine Regelungsbaugruppe, eine Stromversorgung und eine Interface-Baugruppe (146) aufweist.

## Claims

1. A converter unit (2) of modular construction, comprising a mounting frame (6), having a double-sided cooling unit (8) constructed to support components on both sides and an intermediate circuit capacitor battery (10) comprising a plurality of capacitors (38), said cooling unit (8) being arranged in the mounting frame (6) above the intermediate circuit capacitor battery (10), with power semiconductors (18, 20) mounted on a first mounting plate (16) of the double-sided cooling unit (8) constructed to support components on both sides, with the control terminals of said power semiconductors (18, 20) linked to a control assembly (32), with an intermediate circuit rail system (58) for to connect the capacitors (38) of the intermediate circuit capacitor battery (10) electrically to each other and to DC-voltage side terminals of the power semiconductors (18, 20), with current rails (22, 24, 26) each connected electrically to an AC-voltage side terminal of the power semiconductors (18, 20) and with a number of cover plates (40, 42, 44, 46, 102, 108) covering the fitted mounting frame (6) such that an air channel results.

2. The converter unit (2) as claimed in claim 1, **characterised in that** further power semiconductors (72) are provided, which are mounted on the second mounting plate (74) of the double-sided cooling unit (8) constructed to support components on both sides, and the control terminals of which are connected to a further control assembly (76) and with current rails (84, 86, 88, 90, 92) each of which is connected electrically to AC-voltage side and DC-voltage side terminals of the power semiconductors (72) and with a rail section (60) which connects the DC-voltage side terminals of the further power semiconductors (72) electrically to the intermediate circuit rail system (58) of the intermediate circuit capacitor plate (10) located on the opposite side of the mounting frame (6).

3. The converter unit (2) as claimed in claim 1, **characterised in that** the current rails (22, 24, 26) each have a current sensor (28).

4. The converter unit (2) as claimed in claim 1 or 2, **characterised in that** semiconductor fuses (156) are arranged between the AC-voltage side terminals of the power semiconductors (18, 20, 72) and the current rails (22, 24, 26, 28, 84, 86, 88) and that pre-charging resistors (Rᵥ) are provided, which are mounted on a mounting plate (16) of the double-sided cooling unit (8) constructed to support components on both sides and which are connected both to a DC-voltage side terminal of the intermediate circuit capacitor battery (10) and a terminal of the control assembly (32, 76).

5. The converter unit (2) as claimed in claim 1, **characterised in that** at least one six-pack module is provided as power semiconductors (18, 20).

6. The converter unit (2) as claimed in claim 1 or 2, **characterised in that** thyristors are provided as power semiconductors (72).

7. The converter unit (2) as claimed in one of the preceding claims, **characterised in that** the cooling unit (8) is designed as an air-cooled unit.

8. The converter unit (2) as claimed in one of claims 1 to 6, **characterised in that** the cooling unit (8) is designed as a liquid-cooled unit.

9. The converter unit (2) as claimed in claim 8, **characterised in that** the liquid-cooled cooling unit (8) is configured such that the capacitors (38) of the intermediate circuit capacitor battery (10) are liquid-cooled.

10. A converter assembly (110) with a converter unit (2) as claimed in claims 1 and 2, **characterised in that** said converter unit (2) is inserted into a basic frame (4) and that a fan unit (112) and an electronic unit (114) are inserted in this basic frame (4), the fan unit (112) being arranged below the converter unit (2) and the electronic unit (114) being arranged next to the converter unit (2).

11. The converter assembly (110) as claimed in claim 10, **characterised in that** the sides and front of the converter assembly are closed off by covers and that said converter assembly (110) is provided with a mains terminal and a motor terminal arranged above and below the assembly.

12. The converter assembly (110) with a converter unit (2) as claimed in claims 1 and 2 and with a converter unit (2) as claimed in claim 1, **characterised in that** these two converter units (2) are inserted next to each other in a basic frame (4) and that a fan unit (112) is inserted below each converter unit (2) and that an electronic unit (114) is inserted into said basic frame (4) next to these adjacent converter units (2).

13. The converter assembly (110) with two converter units (2) as claimed in claim 1, **characterised in that** these two converter units (2) are inserted next to each other in a basic frame (4), that a fan unit (112) is inserted below each converter unit (2) and that an electronic unit (114) is inserted into said basic frame (4) next to these adjacent converter units (2).

14. The converter assembly (110) with three converter units (2) as claimed in claim 1, **characterised in that** these three converter units (2) are inserted next to each other in a basic frame (4), that a fan unit (112) is inserted below each converter unit (2) and that an electronic unit (114) is inserted into said basic frame (4) next to these adjacent converter units (2).

15. The converter assembly (110) with four converter units (2) as claimed in claim 1, **characterised in that** these converter units (2) are inserted next to each other in a basic frame (4), that a fan unit (112) is inserted below each converter unit (2) and that an electronic unit (114) is inserted into said basic frame (4) next to these adjacent converter units (2).

16. The converter assembly (110) according to one of claims 10 to 15, **characterised in that** the electronic unit (2) has at least one regulator assembly, a power supply and an interface assembly.

## Revendications

1. Unité de redresseur (2) en construction modulaire, qui comprend un châssis de montage (6), comportant un dispositif de refroidissement (8) pouvant être équipé en double face et une batterie de condensateurs de circuit intermédiaire (10) constituée de plusieurs condensateurs (38), ce dispositif de refroidissement (8) étant agencé dans le châssis de montage (6) au-dessus de la batterie de condensateurs de circuit intermédiaire (10), comportant des semi-conducteurs de puissance (18, 20) qui sont montés sur une première plaque de montage (16) du dispositif de refroidissement (8) pouvant être équipé en double face et dont les bornes de connexion de commande sont reliées à un module de commande (32), comportant un système de connectique à rail de circuit intermédiaire (58), qui relie électriquement les condensateurs (38) de la batterie de condensateurs de circuit intermédiaire (10) entre eux et à des bornes de connexion côté courant continu des semi-conducteurs de puissance (18, 20), comportant des barrettes de connexion (22, 24, 26) qui sont reliées électriquement respectivement à une borne de connexion côté courant alternatif des semi-conducteurs de puissance (18, 20), et comportant plusieurs tôles de recouvrement (40, 42, 44, 46, 102, 108) qui réalisent un capotage du châssis de montage (6) équipé, de manière qu'il en résulte un canal d'air.

2. Unité de redresseur (2) selon la revendication 1, **caractérisée en ce que** sont prévus d'autres semi-conducteurs de puissance (72) qui sont montés sur la deuxième plaque de montage (74) du dispositif de refroidissement (8) pouvant être équipé en double face, et dont les bornes de connexion de commande sont reliées à un autre module de commande (76), l'unité comportant des barrettes de connexion (84, 86, 88, 90, 92) qui sont reliées électriquement respectivement à des bornes de connexion côté courant continu et côté courant alternatif des semi-conducteurs (72), et comportant également une pièce de connectique à rail (60) qui relie électriquement les bornes de connexion côté courant continu desdits autres semi-conducteurs (72) au système de connectique à rail de circuit intermédiaire (58) de la plaque de condensateurs de circuit intermédiaire (10) sur le côté opposé du châssis de montage (6).

3. Unité de redresseur (2) selon la revendication 1,
**caractérisée en ce que** les barrettes de connexion (22, 24, 26) comportent chacune un détecteur de courant (28).

4. Unité de redresseur (2) selon la revendication 1 ou 2, **caractérisée en ce qu'**entre les bornes de connexion côté courant alternatif des semi-conducteurs de puissance (18, 20, 72) et les barrettes de connexion (22, 24, 26, 84, 86, 88) sont agencés respectivement des coupe-circuits de protection de semi-conducteur (156), et **en ce que** sont prévues des résistances de charge primaires (Rv) qui sont montées sur une plaque de montage (16) du dispositif de refroidissement (8) pouvant être équipé en double face, et qui d'une part sont reliées à une borne de connexion côté courant continu de la batterie de condensateurs de circuit intermédiaire (10) et d'autre part à une borne de connexion du module de commande (32, 76).

5. Unité de redresseur (2) selon la revendication 1, **caractérisée en ce qu'**en guise de semi-conducteurs (18, 20), il est prévu au moins un module du type Six-Pack.

6. Unité de redresseur (2) selon la revendication 1 ou 2, **caractérisée en ce qu'**en guise de semi-conducteurs (72) sont prévus des thyristors.

7. Unité de redresseur (2) selon l'une des revendications précédentes, **caractérisée en ce que** le dispositif de refroidissement (8) est d'une réalisation à refroidissement par air.

8. Unité de redresseur (2) selon l'une des revendications 1 à 6, **caractérisée en ce que** le dispositif de refroidissement (8) est d'une réalisation à refroidissement par liquide.

9. Unité de redresseur (2) selon la revendication 8, **caractérisée en ce que** le dispositif de refroidissement (8) à refroidissement par liquide est conçu de façon à ce que les condensateurs (38) de la batterie de condensateurs de circuit intermédiaire (10) soient refroidis par liquide.

10. Appareil redresseur (110) comprenant une unité de redresseur (2) selon les revendications 1 et 2, **caractérisé en ce que** cette unité de redresseur (2) est insérée dans un châssis de base (4), et **en ce que** dans ce châssis de base sont insérés une unité de ventilateur (112) et une unité électronique (114), l'unité de ventilateur (112) étant agencée en-dessous et l'unité électronique (114) à côté de l'unité de redresseur (2).

11. Appareil redresseur (110) selon la revendication 10, **caractérisé en ce que** les côtés et la face avant de l'appareil redresseur (110) sont fermés par des éléments de recouvrement, et **en ce que** cet appareil redresseur (110) est pourvu d'une connexion de branchement de réseau et d'une connexion de branchement de moteur, qui sont placées sur le haut et le bas de l'appareil.

12. Appareil redresseur (110) comprenant une unité de redresseur (2) selon les revendications 1 et 2 et une unité de redresseur (2) selon la revendication 1, **caractérisé en ce que** ces deux unités de redresseur (2) sont insérées côte à côte dans un châssis de base (4) et **en ce que** sous chaque unité de redresseur (2) est insérée une unité de ventilateur (112), et **en ce qu'**à côté de ces unités de redresseur (2) voisines est insérée une unité électronique (114) dans ledit châssis de base (4).

13. Appareil redresseur (110) comprenant deux unités de redresseur (2) selon la revendication 1, **caractérisé en ce que** ces deux unités de redresseur (2) sont insérées côte à côte dans un châssis de base (4), **en ce que** sous chaque unité de redresseur (2) est insérée une unité de ventilateur (112), et **en ce qu'**à côté de ces unités de redresseur (2) voisines est insérée une unité électronique (114) dans ledit châssis de base (4).

14. Appareil redresseur (110) comprenant trois unités de redresseur (2) selon la revendication 1, **caractérisé en ce que** ces trois unités de redresseur (2) sont insérées côte à côte dans un châssis de base (4), **en ce que** sous chaque unité de redresseur (2) est insérée une unité de ventilateur (112), et **en ce qu'**à côté de ces unités de redresseur (2) voisines est insérée une unité électronique (114) dans ledit châssis de base (4).

15. Appareil redresseur (110) comprenant quatre unités de redresseur (2) selon la revendication 1, **caractérisé en ce que** ces unités de redresseur (2) sont insérées côte à côte dans un châssis de base (4), **en ce que** sous chaque unité de redresseur (2) est insérée une unité de ventilateur (112), et **en ce qu'**à côté de ces unités de redresseur (2) voisines est insérée une unité électronique (114) dans ledit châssis de base (4).

16. Appareil redresseur (110) selon l'une des revendications 10 à 15, **caractérisé en ce que** l'unité électronique (114) comprend au moins un module de régulation, une alimentation en courant et un module d'interface (146).
